# EUROPÄISCHE PATENTSCHRIFT

(11) **EP 1 724 922 B1**
(45) Veröffentlichungstag und Bekanntmachung des Hinweises auf die Patenterteilung: **25.01.2017**
(21) Anmeldenummer: 06008634.5
(22) Anmeldetag: 26.04.2006
(51) Int. Cl.: H03K 3/53, H03K 17/78, H01S 5/042

(54) **Schaltungsanordnung zur Generierung von Lichtpulsen**
Circuit for generating light pulses
Circuit pour la génération d'impulsions lumineuses

(30) Priorität: 18.05.2005 DE 102005022715
(43) Veröffentlichungstag der Anmeldung: 22.11.2006
(73) Patentinhaber: Leuze electronic GmbH + Co. KG, 73277 Owen/Teck (DE)
(72) Erfinder: Brunner, Rolf, 82223 Eichenau (DE); Auer, Robert, 81373 München (DE); Kappeler, Franz, Prof. Dr., 82178 Puchheim (DE)
(74) Vertreter: Ruckh, Rainer Gerhard

(56) Entgegenhaltungen:
- DE-A1- 19 514 062
- JP-A- 1 117 382
- US-A- 5 089 727
- US-A1- 2003 039 280

## Beschreibung

Die Erfindung betrifft eine Schaltungsanordnung gemäß dem Oberbegriff des Anspruchs 1.

Derartige Schaltungsanordnungen werden insbesondere als Sendereinheiten in optischen Sensoren eingesetzt. Die optischen Sensoren können dabei als Distanzsensoren ausgebildet sein, wobei diese typischerweise nach einem Lichtlaufzeitverfahren arbeiten. Zur Distanzmessung werden mittels der Schaltungsanordnung in der Sendereinheit in einem vorgegebenen Takt Lichtpulse generiert. Als Maß für die Distanz eines Objekts zum optischen Sensor wird die Laufzeit eines Lichtpulses zum Objekt und zurück zum optischen Sensor ausgewertet.

Zur Erzielung einer hochgenauen Distanzmessung ist es erforderlich, Folgen von sehr kurzen Lichtpulsen zu generieren, wobei die Pulsdauer eines Lichtpulses typischerweise bei etwa einer Nanosekunde liegt. Dementsprechend besteht auch die Forderung sehr kurzer Anstiegszeiten derartiger Lichtpulse, die unterhalb einer Nanosekunde liegen.

Derartige Schaltungsanordnungen zur Generierung derartiger kurzer Lichtpulse arbeiten mit Laserdioden als elektro-optische Wandler. An diese Laserdiode ist über ein Schaltelement, wie zum Beispiel einem Transistor, ein Ladungsspeicher angeschlossen, der typischerweise von einem Ladekondensator gebildet ist.

Durch Schließen des Schaltelements wird der Ladekondensator entladen, wodurch ein Stromimpuls erzeugt wird, der in der Laserdiode in einen Lichtpuls umgesetzt wird.

Bei idealen Bauteilen einer derartigen Schaltungsanordnung ergäbe sich ein zeitlicher Verlauf des Stromimpulses, der einer Entladung eines idealen RC-Glieds entspräche. Dies würde eine unendlich schnelle Anstiegzeit des Strompulses und ein exponentielles Abklingen des Strompulses bedeuten.

Im realen Fall ergeben sich jedoch, insbesondere bedingt durch parasitäre Induktivitäten in den verwendeten Bauteilen, systembedingt Abweichungen von dem idealen zeitlichen Verlauf derartiger Strompulse.

Als erste Abweichung wird anstelle einer unendlich schnellen Anstiegszeit eine endliche Anstiegszeit des Strompulses erhalten. Weiterhin weist der zeitliche Verlauf des Strompulses die von der Entladung eines RLC-Glieds bekannte Form auf. Dementsprechend treten bei Abklingen des Strompulses Nachschwinger auf. Diese Nachschwinger umfassen negative Unterschwinger, auf welche positive Überschwinger folgen. Die negativen Unterschwinger polen die Laserdiode in Sperrrichtung um und bewirken einen Zehnerbruch des pn-Überganges der Laserdiode, wodurch deren Lebensdauer drastisch reduziert wird.

Falls die positiven Überschwinger des Strompulses einen bestimmten Amplitudenwert überschreiten, können dadurch auf den eigentlichen Lichtpuls folgend weitere parasitäre Lichtpulse in der Laserdiode generiert werden, die zu einer Verfälschung der Distanzmessungen führen können.

In der DE 195 14 062 A1 ist eine Treiberstufe für gepulste Halbleiterlaser, insbesondere gepulste Hochleistungs-Laserdioden beschrieben. Die Treiberstufe umfasst einen Energiespeicherkondensator mit niedriger Impedanz. Die Modulation des Stromeintrags in ein Laserdiodenarray erfolgt mittels eines optisch schaltbaren Halbleiterschalters. Bevorzugt ist der Energiespeicherkondensator ein Streifenleiter, so dass die Entladung bei geschlossenem Halbleiterschalter in Form eines Stromimpulses erfolgt, dessen Dauer von der Länge des Streifenleiters bestimmt wird. Der Streifenleiter weist bevorzugt eine konstante oder eine veränderliche Impedanz über seine Länge auf. Zwischen dem HalbleiterSchalter und dem Laserdiodenarray ist zur Impedanzanpassung ein Widerstand vorgesehen.

Der Erfindung liegt die Aufgabe zugrunde, eine Schaltungsanordnung der eingangs genannten Art bereitzustellen, mittels derer Lichtpulse mit möglichst geringen Anstiegszeiten und ohne störende Nachschwinger generiert werden können.

Zur Lösung dieser Aufgabe sind die Merkmale des Anspruchs 1 vorgesehen. Eine erfindungsgemäße Verwendung ist in Anspruch 16 aufgeführt. Vorteilhafte Ausführungsformen und zweckmäßige Weiterbildungen der Erfindung sind in den Unteransprüchen beschreiben.

Die Erfindung betrifft eine Schaltungsanordnung zur Generierung von Lichtpulsen. Sie besteht aus einem elektro-optischen Wandler, welcher über ein Schaltelement an einen Ladungsspeicher angeschlossen ist. Durch Schließen des Schaltelements wird ein Ladevorgang des Ladungsspeichers ausgelöst und dadurch ein Strompuls generiert, welcher in dem elektro-optischen Wandler in einen Lichtpuls umgesetzt wird. Zwischen dem Ladungsspeicher und dem Schaltelement sowie dem Schaltelement und dem elektro-optischen Wandler weist die Schaltungsanordnung zur komplexen Impedanzanpassung Anpassungsschaltungen auf, mittels derer Nachschwinger der Stromimpulse vermieden werden. Zur Impedanzanpassung zwischen dem Ladungsspeicher und dem Schaltelement ist eine erste Anpassungsschaltung als separate Einheit vorgesehen, welche eine Anordnung von RC-Gliedern aufweist. Alternativ ist zur Impedanzanpassung zwischen dem Ladungsspeicher und dem Schaltelement eine im Ladungsspeicher integrierte erste Anpassungsschaltung vorgesehen, welche eine Anordnung von Induktivitäten aufweist, welche die Kondensatoren des Ladungsspeichers trennen, wobei den Induktivitäten der ersten Anpassungsschaltung Widerstände als weitere Bestandteile der ersten Anpassungsschaltung zugeordnet sind. Zur Impedanzanpassung zwischen dem Schaltelement und dem elektro-optischen Wandler ist eine zweite Anpassungsschaltung als separate Einheit angeordnet, welche wenigstens ein RC-Glied oder ein RLC-Glied aufweist.

Der Grundgedanke der Erfindung besteht darin, dass durch die erfindungsgemäße Impedanzanpassung mittels der Anpassungsschaltungen zwischen Ladungsspeicher und dem Schaltelement einerseits und dem Schaltelement und dem elektro-optischen Wandler, welcher bevorzugt von einer Laserdiode gebildet ist, andererseits keine sich überlagernde Strom- bzw. Spannungswellen entstehen. Derartige zwischen den Bauteilen der Schaltungsanordnung verlaufende und an diesen reflektierte Strom- und Spannungswellen bilden die wesentliche Ursache für das Auftreten von Nachschwingern in den in der Schaltungsanordnung generierten Strompulsen.

Durch eine Vermeidung oder zumindest eine signifikante Reduzierung der Strom- und Spannungswellen werden somit systematisch Nachschwinger in den Strompulsen vermieden, insbesondere negative Unterschwinger, die zur Verminderung der Lebensdauer der den elektro-optischen Wandler bildenden Laserdiode führen. Auch positive Überschwinger, die zur Emission unerwünschter parasitärer Lichtpulse durch die Laserdiode führen würde, werden vermieden. Weiterhin wird mit der erfindungsgemäßen Schaltungsanordnung auch eine signifikante Verkürzung der Anstiegszeiten der Strom- und Lichtpulse erhalten.

Die erfindungsgemäße Schaltungsanordnung kann damit besonders vorteilhaft als Sendereinheit in optischen Sensoren, insbesondere nach einem Lichtlauf zeitverfahren arbeitenden Distanzsensoren eingesetzt werden. Mit diesen Distanzsensoren können damit hochgenaue und schnelle Distanzmessungen durchgeführt werden.

Die Anpassungsschaltungen zur Eliminierung von zwischen den Bauteilen der Schaltungsanordnung laufenden Strom- und Spannungswellen weisen einen einfachen Aufbau auf und können somit kostengünstig hergestellt werden. Die Komponenten der Anpassungsschaltungen können dabei generell von aktiven und/oder passiven Bauelementen gebildet sein.

Generell erfolgt eine Dimensionierung der Bauelemente der Anpassungsschaltungen derart, dass dabei parasitäre Induktivitäten des Ladungsspeichers, des Schaltelements und des elektro-optischen Wandlers mit einbezogen werden. Damit werden mit den Anpassungsschaltungen Leitungen mit definierten Wellenwiderständen und Grenzfrequenzen nachgebildet, die Reflexionen von Strom- und Spannungswellen zwischen dem Ladungsspeicher und dem Schaltelement einerseits und dem Schaltelement und dem elektro-optischen Wandler andererseits eliminieren oder zumindest stark vermindern.

In einer vorteilhaften Ausführungsform der Erfindung ist eine erste Anpassungsschaltung als separate Einheit zur Anpassung des Innenwiderstands des Ladungsspeichers an den komplexen Eingangswiderstand des Schaltelements vorgesehen. Weiterhin ist eine zweite Anpassungsschaltung als separate Einheit zur Impedanzanpassung zwischen Schaltelement und elektro-optischem Wandler vorgesehen. Bei dieser Ausführungsform kann der Ladungsspeicher insbesondere von einem einzelnen Ladekondensator gebildet sein.

In einer weiteren vorteilhaften Ausführungsform der Erfindung kann die erste Anpassungsschaltung in dem Ladungsspeicher integriert sein. In diesem Fall besteht der Ladungsspeicher bevorzugt aus einer Mehrfachanordnung von Lade-Kondensatoren, die mit den Bauelementen der ersten Anpassungsschaltung ein Schaltungsnetzwerk bilden.

Die Erfindung wird im Nachstehenden anhand der Zeichnungen erläutert. Es zeigen:
- Figur 1:: Schematische Darstellung einer Schaltungsanordnung gemäß dem Stand der Technik zur Generierung von Lichtpulsen.
- Figur 2:: Zeitlicher Verlauf eines idealen, mit der Schaltungsanordnung gemäß Figur 1 generierten Strompulses.
- Figur 3:: Zeitlicher Verlauf eines realen, mit der Schaltungsanordnung gemäß Figur 1 generierten Strompulses.
- Figur 4:: Schematische Darstellung einer ersten Ausführungsform der erfindungsgemäßen Schaltungsanordnung zur Generierung von Lichtpulsen.
- Figur 5:: Detaildarstellung einer Schaltungsanordnung gemäß Figur 4.
- Figur 6:: Zeitlicher Verlauf eines in einer Schaltungsanordnung gemäß Figur 4 generierten Strompulses und Lichtpulses.
- Figur 6a, b:: Darstellung der zeitlichen Verläufe von Teilströmen in der Schaltungsanordnung gemäß Figur 5.
- Figur 7:: Detaildarstellung einer zweiten Ausführungsform der erfindungsgemäßen Schaltungsanordnung zur Generierung von Lichtpulsen.

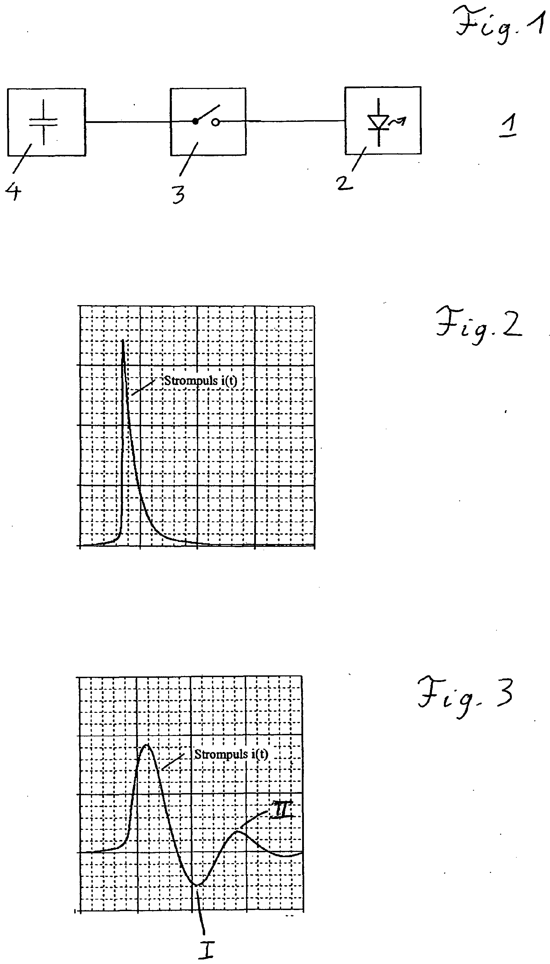

Figur 1 zeigt eine Schaltungsanordnung 1 gemäß dem Stand der Technik mit welcher kurze Lichtpulse generiert werden. Die Schaltungsanordnung weist als elektro-optischem Wandler eine Laserdiode 2 auf, welche Laserlicht emittiert. Damit die Laserdiode 2 kurze, vorzugsweise im Bereich einer Nanosekunde liegende Lichtpulse emittiert, ist an diese über ein elektronisches Schaltelement 3 ein Ladungsspeicher angeschlossen, welcher im vorliegenden von einem Ladekondensator 4 gebildet ist. Das Schaltelement 3 ist von einem Transistor, insbesondere einem Avalanche-Transistor, gebildet.

Zur Erzeugung eines Lichtpulses wird über ein externes Triggersignal das Schaltelement 3 geschlossen. Dadurch entlädt sich der Ladekondensator 4 und erzeugt dabei einen Strompuls i(t) durch die Laserdiode 2. Dieser Strompuls wird in der Laserdiode 2 in einen Lichtpuls p(t) umgesetzt.

Figur 2 zeigt den zeitlichen Verlauf des Strompulses i(t), welchem der zeitliche Verlauf des Lichtpulses p(t) im Wesentlichen entspricht, für den Fall, dass die Komponenten der Schaltungsanordnung 1 ideale Bauelement bilden. In diesem Idealfall weist der Strompuls eine unendlich kurze Anstiegszeit auf und weist entsprechend der Charakteristik eines RC-Glieds ein exponentielles Abklingverhalten auf.

Aufgrund systembedingter parasitärer Eigeninduktivitäten der Bauteile der Schaltungsanordnung 1 sowie Anschlussinduktivitäten des Transistors und der Laserdiode 2 entstehen jedoch generell Abweichungen von diesem idealen zeitlichen Verlauf des Strompulses i(t).

Figur 3 zeigt den realen zeitlichen Verlauf des Strompulses i(t) für die Schaltungsanordnung 1 gemäß Figur 1. Aufgrund von parasitären Induktivitäten in der Schaltungsanordnung 1 wird eine endliche Anstiegszeit des Strompulses i(t) erhalten. Weiterhin ergibt sich aufgrund der vorhandenen parasitären Induktivitäten ein einem RLC-Glied entsprechendes Abklingverhalten des Strompulses i(t). Wie aus Figur 3 ersichtlich, wird somit kein exponentielles Abklingen des Strompulses erhalten. Vielmehr folgt auf den positiven Strompuls i(t) ein negativer Unterschwinger I, gefolgt von einem positiven Überschwinger II. Derartige Unterschwinger polen die Laserdiode 2 in Sperrrichtung und bewirken einen Zenerdurchbruch des pn-Übergangs, wodurch die Lebensdauer der Laserdiode 2 erheblich reduziert wird. Für den Fall, dass die positiven Überschwinger eine bestimmte Amplitude überschreiten, generieren diese auf den mit dem Strompuls i(t) generierten Lichtpuls weitere parasitäre Lichtpulse. Wird die Schaltungsanordnung 1 beispielsweise zur Durchführung von Distanzmessungen nach einem Lichtlaufzeitverfahren eingesetzt, führen diese parasitären Lichtpulse zu Fehlern in den Distanzmessungen.

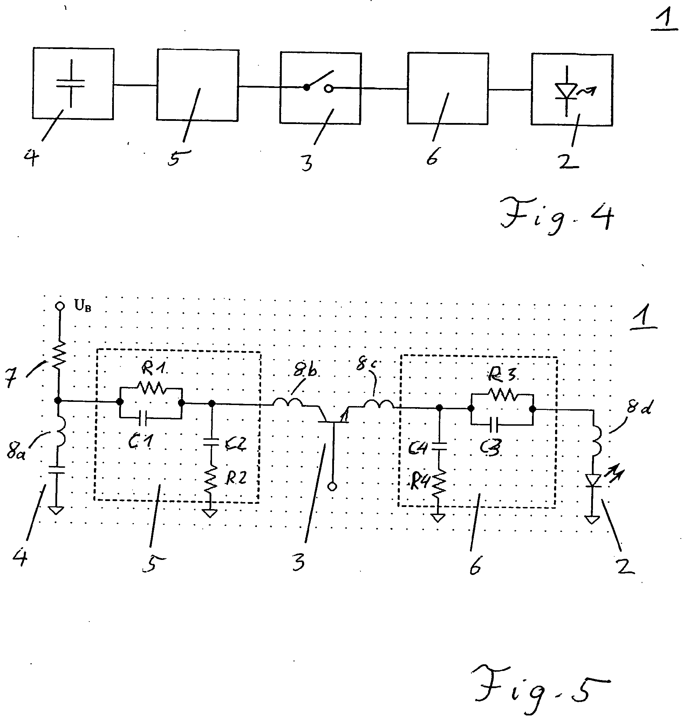

Figur 4 zeigt den prinzipiellen Aufbau eines Ausführungsbeispiels der erfindungsgemäßen Schaltungsanordnung 1, mit welcher derartige Störeinflüsse bedingt durch parasitäre Induktivitäten innerhalb der Schaltungsanordnung 1 weitgehend eliminiert werden.

Entsprechend der Schaltungsanordnung 1 gemäß Figur 1 weist die Schaltungsanordnung 1 gemäß Figur 4 eine Laserdiode 2 auf, an welche ein Ladekondensator 4 und ein Schaltelement 3 angeschlossen sind. Das Schaltelement 3 kann wiederum von einem Transistor, insbesondere einem Avalanche-Transistor, MOS-FET-Transistor oder IGBT-Transistor gebildet sein. Zur Eliminierung der genannten Störeinflüsse ist zwischen dem Ladekondensator 4 und dem Schaltelement 3 eine erste Anpassungsschaltung 5 vorgesehen. Weiterhin ist zwischen dem Schaltelement 3 und dem elektro-optischen Wandler eine zweite Anpassungsschaltung 6 vorgesehen.

Figur 5 zeigt eine mögliche schaltungstechnische Realisierung der Schaltungsanordnung 1 gemäß Figur 4. Das Schaltungselement 3 ist in diesem Fall von einem Avalanche-Transistor gebildet. Der Ladekondensator 4 ist über einen Widerstand 7 an eine Versorgungsspannung U_{B} angeschlossen.
In Figur 5 sind weiterhin die in der Schaltungsanordnung 1 vorhandenen parasitären Induktivitäten 8a - 8d dargestellt, wobei diese dem Ladekondensator 4, dem Schaltelement 3 und der Laserdiode 2 als Komponenten der Schaltungsanordnung 1 zugeordnet sind.

Zur Elimination des Einflusses dieser parasitären Induktivitäten 8a - 8d sind die beiden Anpassungsschaltungen 5, 6 vorgesehen.

Dabei besteht im vorliegenden Fall die erste Anpassungsschaltung 5 aus zwei RC-Gliedern R₁C₂ und R₂C₂. Die zweite Anpassungsschaltung 6 besteht ebenfalls aus zwei RC-Gliedern R₃C₃ und R₄C₄.

Bei der Dimensionierung der RC-Glieder der beiden Anpassungsschaltungen 5, 6 werden die parasitären Induktiven 8a - 8d miteinbezogen. Damit wird mit der ersten Anpassungsschaltung 5 der komplexe Innenwiderstand des Ladekondensators 4 an den Eingangswiderstand des Schaltelementes 3 angepasst. Mit der zweiten Anpassungsschaltung 6 erfolgt eine Impedanzanpassung zwischen dem Schaltelement 3 und der Laserdiode 2. Durch diese Dimensionierung der ersten Anpassungsschaltung 5 wird erreicht, dass bei Einschalten des Schaltelements 3, d.h. dessen Schließen durch ein externes Triggersignal, nur eine Strom- oder Spannungswelle erhalten wird, die sich vom Ladekondensator 4 in Richtung Schaltelement 3 ausbreitet. Durch die Impedanzanpassung mittels der ersten Anpassungsschaltung 5 wird jedoch eine rückreflektierte Strom- oder Spannungswelle vom Schaltelement 3 zum Ladekondensator 4 vermieden. Mit der zweiten Anpassungsschaltung 6 wird erreicht, dass die dem Schaltelement 3 austretende Strom- oder Spannungswelle ohne Reflexionen an die Laserdiode 2 weitergeleitet wird.

Generell können mit den Anpassungsschaltungen 5, 6 die Einflüsse parasitärer Induktivitäten systematisch kompensiert und dadurch zwischen den Bauelementen der Schaltungsanordnung 1 hin- und herlaufende Strom- und Spannungswellen eliminiert oder zumindest weitgehend unterdrückt werden. Da hierzu die parasitären Induktivitäten in die Dimensionierung der Anpassungsschaltung 5, 6 mit einbezogen werden, kann deren Einfluss auch dann kompensiert werden, wenn als Bauelemente gehäuste Transistoren oder Laserdioden 2 eingesetzt werden, deren Zuleitungsinduktivitäten sehr groß sind.

Durch die erfindungsgemäße Anpassungsschaltung 5, 6 wird somit eine Leitung mit definiertem Wellenwiderstand in der Schaltungsanordnung 1 nachgebildet. Dies führt nicht nur zu erheblichen Verkürzungen der Anstiegszeiten der in der Schaltungsanordnung 1 generierten Strompulse i(t), sondern auch zu Vermeidung von Unter- und Überschwingern beim Abklingverhalten der Strompulse i(t).

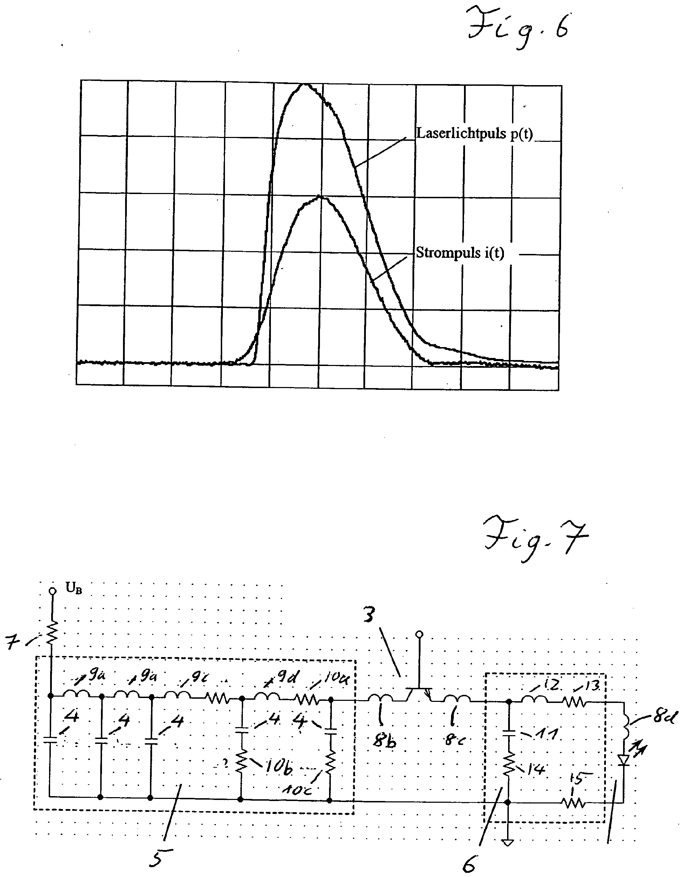

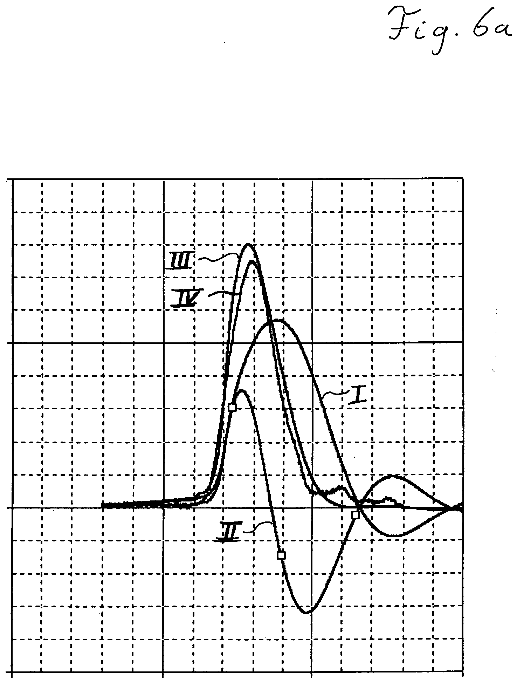

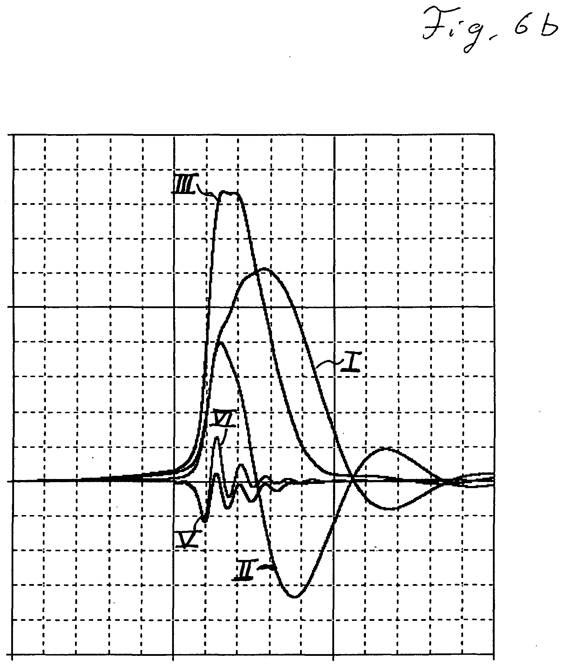

Figur 6 zeigt die typischen zeitlichen Verläufe der in der Schaltungsanordnung 1 gemäß Figur 4 beziehungsweise Figur 5 generierten Strompulse i(t) und dadurch in der Laserdiode 2 generierten Lichtpulse p(t). Wie der Vergleich mit Figur 3 zeigt, wird durch die erfindungsgemäßen Anpassungsschaltungen 5, 6 somit eine erhebliche Verbesserung der Signalverläufe der Strompulse i(t) und damit der Lichtpulse p(t) erhalten.

Die Figuren 6 a, b zeigen unterschiedliche Simulationen der Stromverläufe für die Schaltungsanordnung 1 gemäß Figur 5.

In Figur 6a ist eine Simulation der Schaltungsanordnung 1 gemäß Figur 5 dargestellt, bei welcher mit I und II die zeitlichen Verläufe der Teilströme durch den Widerstand R₃ und den Kondensator C₃ des RC-Glieds R₃C₃ dargestellt sind. Weiterhin ist mit III in Figur 6a der Gesamtstrom durch das RC-Glied R₃C₃ dargestellt, das heißt der sich gemäß der Simulation ergebende Gesamtstrom durch die Laserdiode 2. Mit IV ist der gemessene Strom durch die Laserdiode 2 bezeichnet.

Wie aus den Simulationsergebnissen in Figur 6a ersichtlich, kann durch eine geeignete Dimensionierung der Komponenten R₃ und C₃ des RC-Glieds R₃C₃ der zeitliche Verlauf des Gesamtstroms genau vorgegeben werden. Die beiden Teilströme durch R₃ und C₃ addieren sich zu einer steilen Anstiegsflanke des Gesamtstroms, während der durch induktive Komponenten verursachte Unterschwinger im Strom durch R₃ durch Überschwinger im Strom durch C₃ kompensiert wird. Die Amplituden und die Nulldurchgänge der Teilströme können hierbei durch die Wahl von R₃ und C₃ optimal eingestellt werden.

Figur 6b zeigt eine Erweiterung der Simulation dahingehend, dass neben den Strömen I, II durch R₃ und C₃ als weitere Kompensationsglieder die mit V und VI bezeichneten Zeitkonstanten R₂C₂ und R₄C₄ in der Schaltungsanordnung gemäß Figur 5 zur Bildung des wiederum mit III bezeichneten Gesamtstroms durch die Laserdiode 2 berücksichtigt sind. Durch die Hinzunahme dieser weiteren Kompensationsglieder kann gegenüber der Simulation in Figur 6a die Anstiegszeit und die Pulsform des Gesamtstroms durch die Laserdiode weiter verbessert werden ohne hierbei das Nachschwingverhalten zu verschlechtern.

Figur 7 zeigt ein weiteres Ausführungsbeispiel der erfindungsgemäßen Schaltungsanordnung 1. In Übereinstimmung mit dem Ausführungsbeispiel gemäß Figur 5 weist die Schaltungsanordnung 1 gemäß Figur 7 wiederum als elektro-optischen Wandler eine Laserdiode 2 und als Schaltelement 3 einen Avalanche-Transistor auf. Die Versorgungsspannung U_{B} wird wiederum über den Widerstand 7 auf den Ladungsspeicher geführt. Im vorliegenden Fall besteht der Ladungsspeicher jedoch aus einer Mehrfachanordnung von Ladekondensatoren 4. Dabei sind die Ladekondensatoren 4 in der ersten Anpassungsschaltung 5 integriert. Die zweite Anpassungsschaltung 6 bildet in Übereinstimmung mit dem Ausführungsbeispiel gemäß Figur 5 eine separate Schaltung zwischen den Schaltelementen 3 und der Laserdiode 2.

Die Anpassungsschaltungen 5, 6 dienen wiederum zur Kompensation der Störeinflüsse durch parasitäre Induktivitäten 8b - 8d, das heißt, die Anpassungsschaltungen 5, 6 dienen zur Vermeidung von zwischen dem Ladungsspeicher und Schaltelement 3 einerseits und dem Schaltelement 3 und der Laserdiode 2 andererseits hin- und herlaufenden Strom- und Spannungswellen.

Bei der in Figur 7 gezeigten Ausführungsform sind insgesamt fünf Ladekondensatoren 4 in der ersten Anpassungsschaltung 5 vorgesehen, die durch Induktivitäten 9a - 9d voneinander getrennt sind. Vorteilhafterweise sind anstelle der ersten drei Ladekondensatoren 4, die durch die Induktivitäten 9a, 9b getrennt sind, weitere Ladekondensatoren vorgesehen, die durch entsprechende Induktivitäten getrennt sind. Die beiden letzten Ladekondensatoren 4 sind in ein Netzwerk eingebunden, welches als weitere Komponenten Widerstände 10a - 10c aufweist.

Die zweite Anpassungsschaltung 6 besteht aus einem Kondensator 11, einer Induktivität 12 sowie drei Widerständen 13, 14, 15.

Auch mit dieser Anpassungsschaltung 6 wird in der Schaltungsanordnung 1 eine Leitung mit definiertem Wellenwiderstand und definierter Grenzfrequenz nachgebildet, die Reflexion von Strom- und Spannungswellen innerhalb der Schaltungsanordnung 1 verhindern. Somit wird auch mit dieser Schaltungsanordnung 1 eine Charakteristik der Strompulse i(t) und Lichtpulse p(t) gemäß Figur 6 erhalten. Während die Ausführungsform der Anpassungsschaltung 5, 6 gemäß Figur 5 durch den Einsatz von RC-Gliedern HF-schaltungstechnisch besonders einfach ausgestaltet ist, gelingt mit den Anpassungsschaltungen 5, 6 gemäß Figur 7 eine besonders breitbandige Anpassung an die parasitären Induktivitäten 8b - 8d. Damit ist es möglich, bei vorgegebenen Ausführungsformen der Laserdiode 2 beziehungsweise des Schaltelements 3 eine minimale Anstiegszeit bei gleichzeitiger Kontrolle der Impulsdauer und der Abfallzeit zu erreichen.

Die Schaltungsanordnungen 1 gemäß den Figuren 4, 5 und 7 können besonders vorteilhaft als Sendereinheiten in optischen Sensoren eingesetzt werden. Die optischen Sensoren bilden dabei insbesondere nach dem Lichtlaufzeitverfahren arbeitende Distanzsensoren. Diese werden vervollständigt durch einen Lichtpulse empfangenden Empfänger und eine Auswerteeinheit, in welcher in Abhängigkeit der Empfangssignale des Empfängers die Distanzen von detektierten Objekten ermittelt werden. Bei einem derartigen Distanzsensor emittiert die Laserdiode 2 der Sendereinheit Folgen von Lichtpulsen mit einem vorgegebenen Puls-Pausenverhältnis, wobei die Lichtpulse p(t) durch den Einsatz der Anpassungsschaltungen 5, 6 sehr kurze, typischerweise unterhalb einer Nanosekunde liegende Anstiegszeiten aufweisen und Pulsdauern von etwa einer Nanosekunde aufweisen. Zur Distanzbestimmung wird jeweils die Lichtlaufzeit eines Lichtpulses vom Distanzsensor zu einem Objekt und zurück zum Distanzsensor ausgewertet. Im einfachsten Fall emittiert der Distanzsensor Lichtpulse in einer fest vorgegebenen Richtung. Weiterhin kann der Distanzsensor auch als scannender Sensor ausgebildet sein, bei welchem das emittierte Sendelicht periodisch innerhalb eines flächigen oder räumlichen Überwachungsbereichs abgelenkt wird.

### Bezugszeichenliste

- (1): Schaltungsanordung
- (2): Laserdiode
- (3): Schaltelement
- (4): Ladekondensator
- (5): Anpassungsschaltung
- (6): Anpassungsschaltung
- (7): Widerstand
- (8a): Induktivität
- (8b): Induktivität
- (8c): Induktivität
- (8d): Induktivität
- (9a): Induktivität
- (9b): Induktivität
- (9c): Induktivität
- (9d): Induktivität
- (10a): Widerstand
- (10b): Widerstand
- (10c): Widerstand
- (11): Kondensator
- (12): Induktivität
- (13): Widerstand
- (14): Widerstand
- (15): Widerstand

## Patentansprüche

1. Schaltungsanordnung (1) zur Generierung von Lichtpulsen, mit einem elektro-optischen Wandler, welcher über ein Schaltelement (3) an einen Ladungsspeicher angeschlossen ist, wobei durch Schließen des Schaltelements (3) ein Ladevorgang des Ladungsspeichers ausgelöst und dadurch ein Strompuls generiert wird, welcher in dem elektro-optischen Wandler in einen Lichtpuls umgesetzt wird, wobei diese zur komplexen Impedanzanpassung zwischen dem Ladungsspeicher und dem Schaltelement (3) sowie dem Schaltelement (3) und dem elektro-optischen Wandler Anpassungsschaltungen aufweist, mittels derer Nachschwinger der Stromimpulse vermieden werden, **dadurch gekennzeichnet, dass** zur Impedanzanpassung zwischen dem Ladungsspeicher und dem Schaltelement eine erste Anpassungsschaltung (5) als separate Einheit vorgesehen ist, welche eine Anordnung von RC-Gliedern aufweist, oder dass zur Impedanzanpassung zwischen dem Ladungsspeicher und dem Schaltelement (3) eine im Ladungsspeicher integrierte erste Anpassungsschaltung (5) vorgesehen ist, welche eine Anordnung von Induktivitäten (12) aufweist, welche die Kondensatoren (11) des Ladungsspeichers trennen und den Induktivitäten (12) der ersten Anpassungsschaltung (5) Widerstände (10a-c) als weitere Bestandteile der ersten Anpassungsschaltung (5) zugeordnet sind, und dass zur Impedanzanpassung zwischen dem Schaltelement (3) und dem elektro-optischen Wandler eine zweite Anpassungsschaltung (6) als separate Einheit angeordnet ist, welche wenigstens ein RC-Glied oder ein RLC-Glied aufweist.

2. Schaltungsanordnung (1) nach Anspruch 1, **dadurch gekennzeichnet, dass** der elektro-optische Wandler von einer Laserdiode (2) gebildet ist.

3. Schaltungsanordnung (1) nach einem der Ansprüche 1 oder 2, **dadurch gekennzeichnet, dass** das Schaltelement (3) von einem Transistor gebildet ist.

4. Schaltungsanordnung (1) nach Anspruch 1, **dadurch gekennzeichnet, dass** das Schaltelement (3) von einem Avalanche-Transistor gebildet ist.

5. Schaltungsanordnung (1) nach einem der Ansprüche 1 bis 4, **dadurch gekennzeichnet, dass** durch Schließen des Schaltelements (3) der Ladungsspeicher entladen wird.

6. Schaltungsanordung (1) nach einem der Ansprüche 1 bis 5, **dadurch gekennzeichnet, dass** der Ladungsspeicher aus einem Ladenkondensator (4) besteht.

7. Schaltungsanordnung (1) nach einem der Ansprüche 1 bis 5, **dadurch gekennzeichnet, dass** der Ladungsspeicher eine Mehrfachanordnung von Ladekondensatoren (4) aufweist.

8. Verwendung der Schaltungsanordnung (1) nach einem der Ansprüche 1 bis 7 als Sendereinheit in einem optischen Sensor.

9. Verwendung der Schaltungsanordnung (1) nach Anspruch 8, **dadurch gekennzeichnet, dass** mit dem optischen Sensor Distanzmessungen nach einem Lichtlaufzeitverfahren durchgeführt werden.

## Claims

1. Circuit arrangement (1) for generating light pulses, comprising an electro-optical converter connected by way of a switching element (3) with a charge store, wherein a charging process of the charge store is triggered by closing the switching element (3) and a current pulse which is converted in the electro-optical converter into a light pulse is thereby generated, wherein for complex impedance adaptation between the charge store and the switching element (3) this circuit arrangement comprises, in addition to the switching element (3) and the electro-optical converter, adaptation circuits by means of which post-pulse oscillation of the current pulses is avoided, **characterised in that** for the impedance adaptation between the charge store and the switching element a first adaptation circuit (5), which comprises an arrangement of RC elements, is provided as a separate unit or that for impedance adaptation between the charge store and the switching element (3) a first adaptation circuit (5), which is integrated in the charge store and which comprises an arrangement of inductances (12) separating the capacitors (11) of the charge store, is provided, wherein resistances (10a-c) as further components of the first adaptation circuit (5) are associated with the inductances (12) of the first adaptation circuit (5), and that for impedance adaptation between the switching element (3) and the electro-optical converter a second adaptation circuit (6), which comprises at least one RC element or RLC element, is arranged as a separate unit.

2. Circuit arrangement (1) according to claim 1, **characterised in that** the electro-optical converter is formed by a laser diode (2).

3. Circuit arrangement (1) according to one of claims 1 and 2, characterised isn that the switching element (3) is formed by a transistor.

4. Circuit arrangement (1) according to claim 1, **characterised in that** the switching element (3) is formed by an avalanche transistor.

5. Circuit arrangement (1) according to any one of claims 1 to 4, **characterised in that** the charge store is discharged by closing the switching element (3).

6. Circuit arrangement (1) according to any one of claims 1 to 5, **characterised in that** the charge store consists of a charging capacitor (4).

7. Circuit arrangement (1) according to any one of claims 1 to 5, **characterised in that** the charge store comprises a multiple arrangement of charging capacitors (4).

8. Use of the circuit arrangement (1) according to any one of claims 1 to 7 as a transmitter unit in an optical sensor.

9. Use of the circuit arrangement (1) according to claim 8, **characterised in that** distance measurements in accordance with a light transit time method are carried out by the optical sensor.

## Revendications

1. Circuit (1) pour générer des impulsions lumineuses, comportant un convertisseur électro-optique qui est connecté à un accumulateur de charge par l'intermédiaire d'un élément de commutation (3), la fermeture de l'élément de commutation (3) déclenchant un processus de charge de l'accumulateur de charge et entraînant ainsi la génération d'une impulsion de courant, laquelle est transformée en une impulsion lumineuse dans le convertisseur électro-optique, lequel circuit présente des circuits d'adaptation pour l'adaptation complexe d'impédance entre l'accumulateur de charge et l'élément de commutation (3) ainsi qu'entre l'élément de commutation (3) et le convertisseur électro-optique, au moyen desquels des post-oscillations des impulsions de courant sont évitées,
**caractérisé en ce que** pour l'adaptation d'impédance entre l'accumulateur de charge et l'élément de commutation, un premier circuit d'adaptation (5) est prévu sous la forme d'une unité séparée, lequel présente un agencement de circuits RC, ou que pour l'adaptation d'impédance entre l'accumulateur de charge et l'élément de commutation (3), un premier circuit d'adaptation (5) intégré dans l'accumulateur de charge est prévu, lequel présente un agencement d'inductances (12) qui séparent les condensateurs (11) de l'accumulateur de charge, et des résistances (10a-c) sont associées aux inductances (12) du premier circuit d'adaptation (5) en tant que composants supplémentaires du premier circuit d'adaptation (5), et que pour l'adaptation d'impédance entre l'élément de commutation (3) et le convertisseur électro-optique, un deuxième circuit d'adaptation (6) est disposé sous la forme d'une unité séparée, lequel présente au moins un circuit RC ou un circuit RLC.

2. Circuit (1) selon la revendication 1, **caractérisé en ce que** le convertisseur électro-optique est formé par une diode laser (2).

3. Circuit (1) selon l'une des revendications 1 ou 2, **caractérisé en ce que** l'élément de commutation (3) est formé par un transistor.

4. Circuit (1) selon la revendication 1, **caractérisé en ce que** l'élément de commutation (3) est formé par un transistor à avalanche.

5. Circuit (1) selon l'une des revendications 1 à 4, **caractérisé en ce que** l'accumulateur de charge est déchargé par fermeture de l'élément de commutation (3).

6. Circuit (1) selon l'une des revendications 1 à 5, **caractérisé en ce que** l'accumulateur de charge est constitué d'un condensateur de charge (4).

7. Circuit (1) selon l'une des revendications 1 à 5, **caractérisé en ce que** l'accumulateur de charge présente un agencement multiple de condensateurs de charge (4).

8. Utilisation du circuit (1) selon l'une des revendications 1 à 7 comme unité émettrice dans un capteur optique.

9. Utilisation du circuit (1) selon la revendication 8, **caractérisée en ce que** le capteur optique sert à réaliser des mesures de distance selon un procédé de mesure du temps de vol de la lumière.
